# EUROPÄISCHE PATENTSCHRIFT

(11) **EP 3 265 834 B1**
(45) Veröffentlichungstag und Bekanntmachung des Hinweises auf die Patenterteilung: **13.03.2019**
(21) Anmeldenummer: 16704450.2
(22) Anmeldetag: 15.02.2016
(51) Int. Cl.: G01R 31/28

(54) **ELEKTRISCHE KONTAKTVORRICHTUNG**
ELECTRIC CONTACT DEVICE
DISPOSITIF DE CONTACT ÉLECTRIQUE

(30) Priorität: 03.03.2015 DE 202015001622 U
(43) Veröffentlichungstag der Anmeldung: 10.01.2018
(73) Patentinhaber: Feinmetall GmbH, 71083 Herrenberg (DE)
(72) Erfinder: SCHMID, Rainer, 72124 Pliezhausen (DE)
(74) Vertreter: Clarenbach, Carl-Philipp
(86) Internationale Anmeldenummer: PCT/EP2016/053166
(87) Internationale Veröffentlichungsnummer: WO 2016/139054

(56) Entgegenhaltungen:
- EP-A1- 1 956 376
- EP-A1- 2 026 078
- WO-A1-01/79867

## Beschreibung

Die Erfindung betrifft eine Kontaktvorrichtung für eine elektrische Berührungskontaktierung zur elektrischen Prüfung eines elektrischen Prüflings, insbesondere Wafers.

Kontaktvorrichtungen der eingangs genannten Art sind bekannt. Sie dienen zum elektrischen Berührungskontaktieren eines elektrischen Prüflings, insbesondere Wafers, um diesen auf elektrische Funktionsfähigkeit zu prüfen. Die Kontaktabstände des Prüflings sind in vielen Fällen extrem klein. Aus diesem Grunde ist es erforderlich, dass die Kontaktvorrichtung den kleinen Kontaktabstand derart vergrößert, dass eine Prüfeinrichtung zumeist mittels Kabelverbindungen angeschlossen werden kann, mit deren Hilfe die elektrische Funktionsfähigkeit des Prüflings untersucht wird. Die Prüfeinrichtung schaltet über die Kontaktvorrichtung Prüfstromkreise unter Einbeziehung des Prüflings, wodurch eine Aussage über dessen Funktionsfähigkeit ermöglicht wird. Erschwerend ist, dass eine derartige Prüfung innerhalb eines weiten Temperaturbereichs vorgenommen werden muss, um dem Prüfling eine Funktionsfähigkeit auch in diesem jeweils gewählten Temperaturbereich bescheinigen zu können. Große Temperaturunterschiede führen jedoch auch zu Kontaktierungsproblemen, insbesondere durch temperaturbedingte Verlagerungen von Teilen relativ zueinander aufgrund unterschiedlicher Temperaturausdehnungskoeffizienten. Ferner ist es bisher erforderlich, für jeden Prüfling eine individuell gestaltete Kontaktvorrichtung herzustellen, mit der die Prüfung durchgeführt werden kann, da die Kontaktmuster verschiedener Prüflinge unterschiedlich sind. Die individuelle Fertigung derartiger Kontaktvorrichtungen ist teuer und oftmals langwierig. Die erwähnte, bekannte Kontaktvorrichtung weist eine manuell erstellte und verlötete Verdrahtung auf, die die prüflingsseitige sehr enge Kontaktanordnung in Richtung auf die Prüfeinrichtung "aufweitet", also mit dazu beiträgt, dass entsprechend größere Kontaktabstände vorliegen, die es erlauben, die Prüfeinrichtung elektrisch anzuschließen. Ist die bekannte Kontaktvorrichtung fertig verdrahtet, so werden die Drähte der Verdrahtung durch Eingießen, vorzugsweise mittels eines Kunststoffharzes, befestigt. Die verschiedenen, insbesondere manuellen Arbeitsschritte sind aufwendig und werden individuell unterschiedlich, je nach Arbeitsfertigkeit des tätigen Mitarbeiters und seiner Arbeitsweise, erstellt. Durch diese individuellen Unterschiede entstehen bei Kontaktvorrichtungen, insbesondere Probe Cards, desselben Typs differierende elektrische Eigenschaften, je nach Bearbeitungsqualität durch den Mitarbeiter. Die erwähnte manuelle Lötverdrahtung erfordert geschulte Mitarbeiter, die in der Lage sind, diese filigranen Arbeiten auszuführen. Derartige Mitarbeiter stehen oftmals nicht in ausreichender Zahl zur Verfügung. Durch eine stets zunehmende Verdrahtungsdichte kommt es leicht zu Verdrahtungsfehlern bei den manuellen Arbeiten und die Verdrahtungsgeschwindigkeit nimmt ab, da die hohe Verdrahtungsdichte unübersichtlich ist und auch die Konzentration der Mitarbeiter beeinträchtigt. Sofern in die Verdrahtung elektrische Bauelemente, zum Beispiel Kondensatoren, einbezogen sind, werden die Arbeiten zusätzlich erschwert.

Aus der Offenlegungsschrift WO 01/79867 A1 ist bereits eine Kontaktvorrichtung für eine elektrische Berührungskontaktierung bekannt, mit einem eine Vielzahl von Führungsbohrungen aufweisenden Kontaktkopf, wobei in den Führungsbohrungen federnd ausknickende Kontaktelemente längsverschieblich gelagert sind, deren eine Enden der Berührungskontaktierung eines Prüflings dienen und deren andere Enden in Berührungskontakt zu Kontaktflächen auf einer Seite einer Leiterplatte stehen. Die ersten Kontaktflächen sind mit auf der gegenüberliegenden Seite der Leiterplatte angeordneten zweiten Kontaktflächen elektrisch verbunden.

Der Erfindung liegt daher die Aufgabe zugrunde, eine Kontaktvorrichtung für eine elektrische Berührungskontaktierung zur elektrischen Prüfung eines elektrischen Prüflings, insbesondere Wafers, zu schaffen, die eine gleichbleibend hohe Qualität, insbesondere im Hinblick auf ihre elektrischen Eigenschaften aufweist, fehlerfrei hergestellt werden kann und eine relativ kurze Produktionszeit erfordert. Ferner soll die Kontaktvorrichtung zumindest bereichsweise standardisiert werden, um individuelle Anpassungen an den Prüfling möglichst einfach und weniger aufwendig zu machen, sodass Standardkomponenten hergestellt und auf Lager gelegt werden können und im Auftragsfall einfach und schnell an den individuellen Prüfling anpassbar sind. Schließlich soll die Kontaktvorrichtung im Bedarfsfall elektrische Bauelemente in einfacher Weise aufnehmen können.

Diese Aufgabe wird bei einer Kontaktvorrichtung für eine elektrische Berührungskontaktierung zur elektrischen Prüfung eines elektrischen Prüflings, insbesondere Wafers, mit den Merkmalen des Anspruchs 1 dadurch gelöst, dass er einen Kontaktkopf und mindestens eine Leiterplatine aufweist, wobei der Kontaktkopf eine Vielzahl von Führungsbohrungen aufweist, in denen längliche, durch die Berührungskontaktierung des Prüflings seitlich federnd ausknickende Kontaktelemente längsverschieblich lagern, deren eine Enden der Berührungskontaktierung des Prüflings dienen und deren andere Enden in Berührungskontakt zu in einem vorgegebenen Muster angeordneten, ersten Kontaktflächen stehen, die sich auf einer Seite der Leiterplatine in einem ersten insbesondere zentralen Bereich von dieser befinden, wobei auf der anderen Seite der Leiterplatine in einem zweiten insbesondere zentralen Bereich von dieser insbesondere in einem weiteren vorgegebenen Muster angeordnete, zweite Kontaktflächen liegen, die mit den ersten Kontaktflächen durch die Leiterplatine hindurch elektrisch verbunden sind, auf der anderen Seite der Leiterplatine in mindestens einem ersten insbesondere peripheren Abschnitt von dieser dritte Kontaktflächen liegen, zumindest einige der zweiten Kontaktflächen mit zumindest einigen der dritten Kontaktflächen mittels gebondeter Bonddrähten elektrisch verbunden sind, und wobei zumindest ein Anteil der ersten Kontaktflächen und/oder zumindest ein Anteil der zweiten Kontaktflächen jeweils mittels durchtrennbarer Leiter miteinander elektrisch verbunden sind und mindestens einer dieser Leiter durchtrennt ist. Die erfindungsgemäße Kontaktvorrichtung weist daher - vom Prüfling aus gesehen - folgenden elektrischen Kontaktweg auf: Die Kontaktelemente des Prüfkopfs dienen der Berührungskontaktierung der Prüflingskontakte und stehen in Berührungskontaktierung mit den ersten Kontaktflächen der Leiterplatine. Die ersten Kontaktflächen sind mit den zweiten Kontaktflächen der Leiterplatine verbunden, die sich auf der anderen, prüflingsabgewandten Seite der Leiterplatine befinden. Sie liegen insbesondere zentral und werden über gebondete Drähte (Bonddrähte) mit dritten Kontaktflächen verbunden, die sich in dem mindestens einen insbesondere peripheren Abschnitt der Leiterplatine befinden. Im insbesondere peripheren Abschnitt steht wesentlich mehr Platz zur Verfügung als im vorzugsweise zentralen Bereich, sodass mittels der von den Bonddrähten gebildeten Verdrahtung eine Kontaktabstandsvergrößerung stattfindet. Der periphere Abschnitt kann sich insbesondere um den zentralen Bereich herum erstrecken. Das Bonden kann vorzugsweise automatisch erfolgen, sodass keine manuelle Arbeit hierfür anfällt. Die jeweiligen Ausgangs- und Zielkoordinaten für die Bonddrähte lassen sich computerunterstützt einspeisen. Das Bonden, insbesondere automatische/maschinelle Bonden, führt zu optimalen elektrischen Eigenschaften mit gleichbleibend hoher Qualität. Verdrahtungsfehler werden vermieden. Die mit der Herstellung der Kontaktvorrichtung betrauten Mitarbeiter werden insoweit nicht mehr mit den genannten filigranen Arbeiten belastet. Da zumindest ein Anteil der ersten Kontaktflächen und/oder zumindest ein Anteil der zweiten Kontaktflächen jeweils mittels durchtrennbarer Leiter miteinander elektrisch verbunden sind und mindestens einer dieser Leiter durchtrennt ist, lassen sich je nach Lage und Anzahl des/der durchtrennten Leiter Leiterflächen/Leiterstrukturen erzeugen, die kundenspezifisch gewünscht sein können und/oder für das gleiche elektrische Potential zur Verfügung stehen. Gleiche elektrische Signale lassen sich auf diese Art und Weise zusammenfassen. Sehr vorteilhaft ist es, wenn auf diesen Leiterflächen - sofern sie anderweitig nicht gebraucht werden - elektrische/elektronische Bauteile, beispielsweise Kondensatoren, platziert werden, wodurch diese Bauteile sehr nahe am Prüfling angeordnet sind und daher besonders störungsfrei arbeiten. Ausgangspunkt ist mindestens ein Anteil elektrisch miteinander verbundener Kontaktflächen, die dann durch das Durchtrennen von einem oder mehreren Leitern individuell angepasst werden. Durch entsprechendes Durchtrennen der Leiter lassen sich die erwähnten elektrischen Leiterflächen/Leiterstrukturen entweder auf der einen Seite der Leiterplatine aufgrund der ersten Kontaktflächen oder auf der anderen Seite der Leiterplatine mittels der dort liegenden zweiten Kontaktflächen oder auf beiden Seiten der Leiterplatine erschaffen. Zusammenhängende Leiterflächen/Leiterstrukturen können zum Beispiel sehr vorteilhaft für die Zuleitung eines Potentials einer Spannungsversorgung und/oder für das Massepotential verwendet werden.

Eine Weiterbildung der Erfindung sieht vor, dass die durchtrennbaren Leiter als Leiterbahnen oder Leiterstege ausgebildet sind. Die Leiterbahnen sind bevorzugt auf und/oder unterhalb (also innerhalb der Leiterplatine) der Oberfläche der einen und/oder der anderen Seite der Leiterplatine angeordnet. Vorzugsweise können auch die ersten und/oder zweiten Kontaktflächen als dementsprechende Leiterbahnelemente ausgebildet sein und vorzugsweise auf der Oberfläche der einen und/oder der anderen Seite der Leiterplatine liegen. Bei den Leiterstegen handelt es sich um Leiter, die oberhalb der Oberfläche der ersten und/oder zweiten Seite der Leiterplatine verlaufen.

Insbesondere kann vorgesehen sein, dass der mindestens eine durchtrennte Leiter laserdurchtrennt ist. Um die genannten Leiterflächen, also über Leiterbahnen oder Leiterstege zusammenhängende Kontaktflächen zu separieren, werden die geeigneten, Kontaktflächen miteinander verbindenden Leiter durchtrennt, insbesondere mittels Laser durchtrennt. Dieses Laserdurchtrennen kann bevorzugt automatisch erfolgen, d.h., dem die Durchtrennung vornehmenden Laser werden entsprechende Koordinatendatensätze zugeführt, sodass dieser selbsttätig arbeiten kann.

Eine Weiterbildung der Erfindung ist gekennzeichnet durch mindestens eine Leiterplatte, wobei die dritten Kontaktflächen mit Leiteranordnungen der Leiterplatte elektrisch verbunden sind. Oberhalb, neben und/oder unterhalb der mindestens einen Leiterplatine ist die mindestens eine Leiterplatte angeordnet. Diese dient dazu, den Kontaktabstand weiter zu vergrößern und bietet eine Anschlussmöglichkeit an die Prüfeinrichtung. Vorzugsweise werden zwischen der Leiterplatte und der Prüfeinrichtung elektrische Kabelverbindungen und/oder Berührungskontaktierungen hergestellt. Die dritten Kontaktflächen, die sich an der anderen Seite der Leiterplatine befinden, werden elektrisch verbunden mit entsprechenden Leiteranordnungen der Leiterplatte. Die elektrischen Verbindungen zwischen den dritten Kontaktflächen und der Leiterplatte können auf unterschiedliche Art und Weise ausgebildet sein, so wie sich dies aus der Gesamtheit dieser Schutzrechtsanmeldung ergibt. Auch nicht aus dieser Schutzrechtsanmeldung hervorgehende, dem Fachmann bekannte Verbindungen können Anwendung finden.

Eine Weiterbildung der Erfindung sieht vor, dass auf der einen Seite der Leiterplatine in mindestens einem zweiten insbesondere peripheren Abschnitt von dieser erste Kontaktbauteile liegen, die mit den dritten Kontaktflächen durch die Leiterplatine hindurch elektrisch verbunden sind, die Leiterplatte auf ihrer der Leiterplatine zugewandten Seite zweite Kontaktbauteile aufweist, und wobei die ersten Kontaktbauteile mit den zweiten Kontaktbauteilen mittels elektrischer Verbindungen, insbesondere federnd nachgiebigen Berührungskontaktierungen, elektrisch verbunden sind. Insbesondere befindet sich die Leiterplatte in prüflingsnäherer Position als die Leiterplatine. Von den dritten Kontaktflächen bestehen elektrische Verbindungen zur einen, gegenüberliegenden Seite der Leiterplatine bis zu den dort vorhandenen ersten Kontaktbauteilen, die mit zweiten Kontaktbauteilen einer Leiterplatte federnd nachgiebig durch Berührungskontaktierungen elektrische verbunden sind. Die federnde Nachgiebigkeit erlaubt in einem entsprechend großen Bereich eine Variation in der prüflingsabhängigen / herstellerabhängigen / anwenderabhängigen Bauhöhe, die durch den axialen Abstand zwischen den der Prüflingskontaktierung dienenden Enden der Kontaktelemente und der prüflingszugewandten Seite der Leiterplatte definiert ist. Die axiale Richtung des axialen Abstands ist entlang der Längserstreckung der länglichen Kontaktelemente definiert (hierbei wird das seitlich federnde Ausknicken der Kontaktelemente bei der Berührungskontaktierung nicht berücksichtigt). Auch wenn die genannten Enden der Kontaktelemente zu der erwähnten Seite der Leiterplatte, also die Bauhöhe, bei unterschiedlichen Herstellern/Anwendern von zu testenden Prüflingen unterschiedlich große Maße aufweist, lässt sich mit ein und derselben Kontaktvorrichtung jeder Prüfling prüfen, da die federnde Nachgiebigkeit der Berührungskontaktierungen bezüglich der ersten und zweiten Kontaktbauteile ein Einstellen von unterschiedlichen Bauhöhen an der Kontaktvorrichtung gestattet, sodass sie insoweit universell eingesetzt werden kann.

Vorzugsweise kann bei einem weiteren Ausführungsbeispiel vorgesehen sein, dass auf der anderen Seite der Leiterplatine in mindestens einem zweiten insbesondere peripheren Abschnitt von dieser erste Kontaktbauteile liegen, die mit den dritten Kontaktflächen elektrisch verbunden sind, die Leiterplatte auf ihrer der Leiterplatine zugewandten Seite zweite Kontaktbauteile aufweist, und wobei die ersten Kontaktbauteile mit den zweiten Kontaktbauteilen mittels elektrischer Verbindungen, insbesondere federnd nachgiebigen Berührungskontaktierungen, elektrisch verbunden sind. Insbesondere befindet sich die Leiterplatine in prüflingsnäherer Position als die Leiterplatte. Die im vorstehenden Absatz stehenden Ausführungen gelten bei dem Ausführungsbeispiel dieses Absatzes in entsprechender Weise.

Nach einer Weiterbildung der Erfindung ist vorgesehen, dass die ersten Kontaktbauteile mit den zweiten Kontaktbauteilen über mindestens einen elektrischen Zwischenverbinder (Interposer) elektrisch verbunden sind. Dieser Zwischenverbinder kann bevorzugt als separates Bauteil ausgebildet sein und/oder er wird von Teilen der Leiterplatine und/oder Leiterplatte gebildet oder mitgebildet.

Insbesondere kann vorgesehen sein, dass die ersten Kontaktbauteile und/oder die zweiten Kontaktbauteile vierte Kontaktflächen sind. Diese vierten Kontaktflächen befinden sich demzufolge an der prüflingsseitigen Seite der Leiterplatine und/oder der prüflingsabgewandten Seite der Leiterplatte.

Nach einer Weiterbildung der Erfindung ist vorgesehen, dass die ersten Kontaktbauteile und/oder die zweiten Kontaktbauteile hervorstehende erste Federkontakte sind. Bei dieser Ausführungsform sind somit keine Kontaktflächen vorgesehen, die mittels des Zwischenverbinders miteinander zu verbinden sind, sondern die ersten und/oder zweiten Kontaktbauteile sind erhabene Elemente, also hervorstehende erste Federkontakte, also federnd nachgiebige Elemente. Die ersten Federkontakte der ersten und zweiten Kontaktbauteile können sich direkt berührungskontaktieren oder es ist ein Drittgegenstand dazwischengeschaltet.

Es ist vorteilhaft, wenn der Zwischenverbinder auf einander gegenüberliegenden Seiten Kontakteinrichtungen aufweist, die als fünfte Kontaktflächen und/oder hervorstehende zweite Federkontakte ausgebildet sind. Sofern die ersten und zweiten Kontaktbauteile als vierte Kontaktflächen ausgebildet sind und der Zwischenverbinder, der sich zwischen diesen ersten und zweiten Kontaktbauteilen befindet, an einander gegenüberliegenden Seiten Kontakteinrichtungen aufweist, die als hervorstehende zweite Federkontakte ausgebildet sind, wird jeweils eine vierte Kontaktfläche der Leiterplatine mit einer vierten Kontaktfläche der Leiterplatte von den hervorstehenden zweiten Federkontakten berührungskontaktiert, wobei diese beiden zweiten Federkontakte untereinander elektrisch verbunden sind.

Die Erfindung sieht vor, dass das vorgegebene Muster der Anordnung der ersten Kontaktflächen und/oder das insbesondere vorgegebene weitere Muster der zweiten Kontaktflächen jeweils ein zweidimensionales Matrixmuster ist. Die Kontaktflächen sind also schachbrettartig angeordnet. In einer entsprechenden Anordnung liegen die prüflingsabgewandten Enden der Kontaktelemente, sodass es zu einwandfreien elektrischen Berührungskontaktierungen zwischen diesen Bauteilen bei einem Prüfvorgang des elektrischen Prüflings kommt. Zusätzlich oder alternativ können die zweiten Kontaktflächen in einem weiteren zweidimensionalen Muster angeordnet sein.

Eine Weiterbildung der Erfindung sieht vor, dass die Führungsbohrungen im Bereich der Leiterplatine in dem vorgegebenen Muster, insbesondere zweidimensionalen Matrixmuster, angeordnet sind. Hierauf wurde unmittelbar vorstehend bereits eingegangen.

Vorzugsweise ist vorgesehen, dass die Führungsbohrungen prüflingsseitig in einem dem Prüfling entsprechenden Individualmuster angeordnet sind. Sind beispielsweise Führungsbohrungen in einer ersten Führungsplatte vorgesehen, die prüflingsabgewandt liegt und Führungsbohrungen einer zweiten Führungsplatte, die zur ersten Führungsplatte beabstandet liegt und sich im prüflingsnahen Bereich befindet, so führt dies zu Führungsbohrungen, die einerseits in einem vorgegebenen Muster entsprechend der ersten Kontaktflächen liegen und andererseits in einem Individualmuster, das durch die Kontaktanordnung des Prüflings vorgegeben ist. Dies führt dazu, dass sich die länglichen Kontaktelemente nicht alle in axialer Richtung erstrecken, sondern zumindest einige schräg dazu verlaufend angeordnet sind, um vom Individualmuster auf das vorgegebene Muster, insbesondere zweidimensionale Matrixmuster, übergehen zu können. Durch diese Ausgestaltung ist es möglich, eine Vielzahl der hier beschriebenen Bauteile der Kontaktvorrichtung zu fertigen, ohne dass auf den Prüfling oder kundenspezifische Anforderungen eingegangen werden muss. Erst durch die genannte Möglichkeit, einen Übergang zwischen dem Individualmuster und dem vorgegebenen Muster zu schaffen, lassen sich derartige Kontaktvorrichtungen auf den Einzelfall anpassen. Entsprechendes gilt für die erwähnte Bauhöhenanpassung.

Die Erfindung sieht vor, dass die ersten Kontaktflächen mit den zweiten Kontaktflächen über erste Durchkontaktierungen verbunden sind. Demzufolge wird die Leiterplatine, die auch als Tochterplatine bezeichnet werden kann, die insbesondere einen leiterplattenentsprechenden Aufbau besitzt, von den ersten Durchkontaktierungen durchsetzt, wodurch die ersten Kontaktflächen mit den zweiten Kontaktflächen elektrisch verbunden werden. Die Leiterplatine und/oder die Leiterplatte kann/können in Singlelayer- oder Multilayer-Bauweise ausgebildet sein. Insbesondere ist vorgesehen, dass sich zumindest einige der ersten Durchkontaktierungen jeweils aus mehreren ersten Durchkontaktierungsbereichen zusammensetzen, wobei bei diesen ersten Durchkontaktierungen jeweils die ersten Durchkontaktierungsbereiche fluchtend und/oder versetzt, jedoch zumindest teilweise überlappend zueinander liegen. Die einzelnen Durchkontaktierungsbereiche sind somit aneinandergereiht ausgebildet, um eine elektrische Verbindungsbahn zu schaffen, wobei bei fluchtend zueinander liegenden Durchkontaktierungsbereichen die Lage der ersten Kontaktfläche zur zugehörigen zweiten Kontaktfläche axial fluchtend liegt. Sind jedoch zumindest einige der ersten Durchkontaktierungsbereiche einer derartigen Durchkontaktierung versetzt zueinander angeordnet, wobei jedoch eine teilweise Überlappung erhalten bleibt, so führt das zu einem Schrägverlauf der elektrischen Kontaktbahn mit der Folge, dass hierdurch insbesondere der Kontaktabstand vergrößert werden kann, d.h., die ersten Kontaktflächen weisen zueinander einen engeren Kontaktabstand auf als die zweiten Kontaktflächen. Dies muss nicht für alle derartige Kontaktflächen gelten, zumindest jedoch für einige von ihnen. Insofern vereinfacht sich das auf den zweiten Kontaktflächen durchzuführende Bonden der Bonddrähte, da ein größerer Kontaktabstand vorliegt.

Eine Weiterbildung der Erfindung sieht vor, dass die dritten Kontaktflächen mit den ersten Kontaktbauteilen über zweite Durchkontaktierungen verbunden sind. Auch wie vorstehend bereits beschrieben, können die zweiten Durchkontaktierungen dazu verwendet werden, Kontaktabstände zu vergrößern oder auch nicht.

Das Vergrößern der Kontaktabstände ist dann gegeben, wenn sich zumindest einige der zweiten Durchkontaktierungen jeweils aus mehreren zweiten Durchkontaktierungsbereichen zusammensetzen, wobei bei diesen zweiten Durchkontaktierungen jeweils die zweiten Durchkontaktierungsbereiche fluchtend und/oder versetzt, jedoch zumindest teilweise überlappend zueinander liegen. Die erwähnten ersten Durchkontaktierungsbereiche und/oder zweiten Durchkontaktierungsbereiche können insbesondere bezüglich eines Schichtaufbaus der Leiterplatine verstanden werden, d.h., es handelt sich insbesondere um ein sogenanntes Multilayer Board, wobei jeder Schicht ein Durchkontaktierungsbereich zugeordnet ist.

Es ist vorteilhaft, wenn die zweiten Kontaktflächen und die dritten Kontaktflächen auf gleicher Höhe liegen. Demzufolge bildet die dem Prüfling angewandt liegende Seite der Leiterplatine eine Ebene. Die Bondarbeiten gestalten sich aufgrund dieser Ebene und der damit einhergehenden Lage der zweiten und dritten Kontaktflächen besonders effektiv und einfach.

Insbesondere kann vorgesehen sein, dass zur Höhenabstandseinstellung von Leiterplatine und Leiterplatte mindestens ein auswechselbares Distanzelement von wählbarer Dicke zwischen Leiterplatine und Leiterplatte angeordnet ist. Je nach gewähltem Distanzelement, also entsprechend dickem Distanzelement lässt sich die sogenannte, vorstehend bereits erläuterte Bauhöhe der Kontaktvorrichtung einstellen, sodass herstellerspezifische/anwenderspezifische Anforderungen in Bezug auf die Prüflinge mit ein und derselben Vorrichtung realisierbar sind.

Nach einer Weiterbildung der Erfindung ist vorgesehen, dass die Kontaktelemente mikrosystemtechnische Kontaktelemente sind. Hierunter sind Bauteile mit kleinsten Abmessungen (im Mikrometerbereich) zu verstehen. Die Mikrosystemtechnik wird auch mit dem Begriff MEMS bezeichnet.

Vorzugsweise ist vorgesehen, dass die dritten Kontaktflächen, die ersten Kontaktbauteile, die zweiten Kontaktbauteile und/oder die Kontakteinrichtungen jeweils mittels durchtrennbarer, insbesondere laserdurchtrennbarer, Leiter miteinander elektrisch verbunden sind, wobei mindestens einer dieser Leiter durchtrennt, insbesondere laserdurchtrennt, ist. Um zum Beispiel Bereiche gleichen elektrischen Potentials zu schaffen, beispielsweise bei mehreren dritten Kontaktflächen, so können diese über die Leiter elektrisch miteinander verbunden bleiben. Will man allerdings bestimmte dritte Kontaktflächen von bestimmten anderen dritten Kontaktflächen trennen oder auch nur eine einzige dritte Kontaktfläche entsprechend separieren, so wird hierzu bei der Herstellung der Kontaktvorrichtung der mindestens eine oder die mindestens mehreren, mit dieser Kontaktfläche/Kontaktflächen verbundenen Leiter durchtrennt, sodass keine Verbindung zu angrenzenden dritten Kontaktflächen besteht. Das Durchtrennen kann mittels unterschiedlicher Technik erfolgen, besonders bevorzugt ist es, wenn die Durchtrennung mittels Laserstrahl durchgeführt wird. Der Laser könnte maschinengesteuert/softwaregesteuert arbeiten, sodass keine manuelle Arbeit anfällt. Beispielsweise lässt sich auf diese Art und Weise ein größerer Kontaktbereich mit einem elektrischen Massepotential erzeugen und/oder ein Kontaktbereich separiert werden, der nicht für die ausknickenden Kontaktelemente benötigt wird und daher zum Beispiel für die Aufnahme eines elektrischen/elektronischen Bauteils zur Verfügung steht. Entsprechendes gilt für die ersten Kontaktflächen, die zweiten Kontaktflächen, die ersten Kontaktbauteile, die zweiten Kontaktbauteile und/oder die Kontakteinrichtungen.

Schließlich ist es vorteilhaft, wenn die Leiter matrixartig angeordnet sind. Sind die genannten Kontaktflächen, Kontaktbauteile und/oder Kontakteinrichtungen in einem vorgegebenen oder weiteren vorgegebenen Muster, beispielsweise matrixartig, angeordnet, so führt dies zu einer entsprechenden Leiteranordnung, also auch in einem dementsprechend vorgegebenen Muster, insbesondere auch matrixartig. So ist es beispielsweise möglich, schachbrettartig angeordnete Kontaktflächen, Kontaktbauteile und/oder Kontakteinrichtungen derart untereinander zu verbinden, dass die Leiter in X- und Y-Richtung einer Ebene verlaufen, auf der sich die Kontaktflächen, Kontaktbauteile und/oder Kontakteinrichtungen befinden.

Mit der erfindungsgemäßen Kontaktvorrichtung lässt sich ein Verfahren zur elektrischen Berührungskontaktierung durchführen, um eine elektrische Prüfung eines elektrischen Prüflings, insbesondere Wafers, vorzunehmen, wobei die Kontaktvorrichtung einen Kontaktkopf und mindestens eine Leiterplatine aufweist, wobei der Kontaktkopf eine Vielzahl von Führungsbohrungen aufweist, in denen längliche, durch die Berührungskontaktierung des Prüflings seitlich federnd ausknickende Kontaktelemente längsverschieblich lagern, deren eine Ende der Berührungskontaktierung des Prüflings dienen und deren andere Enden in Berührungskontakt zu in einem vorgegebenen Muster angeordneten, ersten Kontaktflächen stehen, die sich auf einer Seite der Leiterplatine in einem ersten insbesondere zentralen Bereich von dieser befinden, wobei auf der anderen Seite der Leiterplatine in einem zweiten insbesondere zentralen Bereich von dieser insbesondere in einem weiteren vorgegebenen Muster angeordnete, zweite Kontaktflächen liegen, die mit den ersten Kontaktflächen durch die Leiterplatine hindurch elektrisch verbunden werden, auf der anderen Seite der Leiterplatine in mindestens einem ersten insbesondere peripheren Abschnitt von dieser dritte Kontaktflächen liegen, wobei zumindest einige der zweiten Kontaktflächen mit zumindest einigen der dritten Kontaktflächen mittels Bonden von Bonddrähten elektrisch verbunden werden, und wobei zumindest ein Anteil der ersten Kontaktflächen und/oder zumindest ein Anteil der zweiten Kontaktflächen jeweils mittels Leiter miteinander elektrisch verbunden sind und zumindest einer der Leiter durchtrennt wird, insbesondere laserdurchtrennt wird.

Die Zeichnungen veranschaulichen die Erfindung anhand von Ausführungsbeispielen, und zwar zeigt:
- Figur 1: eine schematische, teilweise geschnittene Ansicht einer Kontaktvorrichtung,
- Figur 2: eine Draufsicht auf eine Leiterplatine der Anordnung der Figur 1,
- Figur 3: einen Ausschnitt aus der Figur 1, jedoch in perspektivischer Ansicht,
- Figuren 4 und 5: Ausschnitte aus der Anordnung der Figur 2 im Ausgangszustand und im bearbeiteten Zustand,
- Figur 6: ein weiteres Ausführungsbeispiel der Kontaktvorrichtung, teilweise geschnitten und
- Figur 7: eine Schnittansicht durch einen Bereich der Leiterplatine gemäß Figur 1 und gemäß Figur 6.

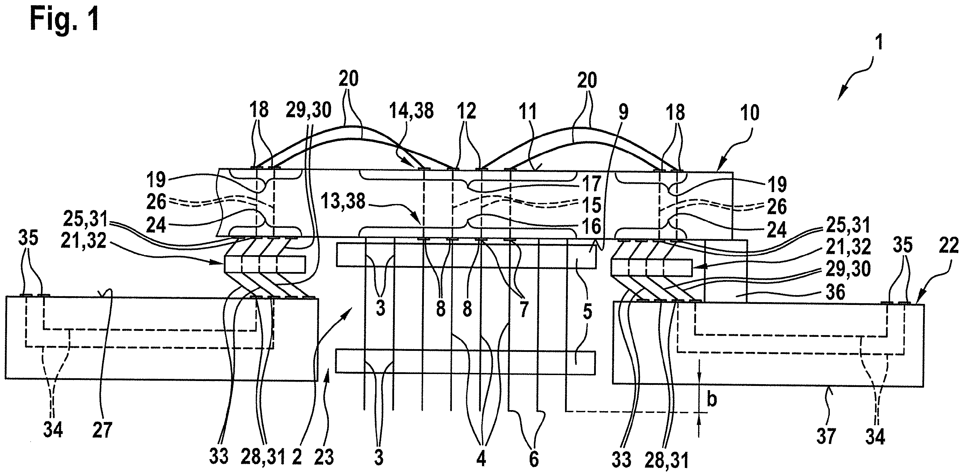

Die Figur 1 zeigt eine Kontaktvorrichtung 1. Die Kontaktvorrichtung 1 dient einer elektrischen Berührungskontaktierung eines elektrischen Prüflings, insbesondere Wafers, um diesen einer elektrischen Prüfung zu unterziehen. Hierzu weist die Kontaktvorrichtung 1 einen Kontaktkopf 2 auf, der mit einer Vielzahl von Führungsbohrungen 3 versehen ist, in denen längliche Kontaktelemente 4 längsverschieblich lagern. In der schematischen Darstellung der Figur 1 weist der Kontaktkopf 2 zwei beabstandet zueinander liegende Führungsplatten 5 auf, die von den erwähnten Führungsbohrungen 3 durchsetzt werden. Es sind jedoch auch andere Ausführungsbeispiele mit mehr als zwei Führungsplatten 5 denkbar. Die einen Enden 6 der Kontaktelemente 4 dienen der elektrischen Berührungskontaktierung eines in der Figur 1 nicht dargestellten Prüflings. Die anderen Enden 7 der Kontaktelemente 4 treten in Berührungskontakt zu Kontaktflächen 8, die sich auf einer Seite 9 einer Leiterplatine 10 befinden. Wird die elektrische Berührungskontaktierung des Prüflings durchgeführt, so führt dies zu einem seitlichen federnden Ausklicken der länglichen Kontaktelemente 4, das heißt, diese bestehen aus elastischem, elektrisch leitfähigem Material. Die Kontaktelemente 4 werden oftmals auch Knickdrähte genannt.

Die auf der einen Seite 9 die Kontaktflächen 8 aufweisende Leiterplatine 10 besitzt auf einer der Seite 9 gegenüberliegenden anderen Seite 11 ebenfalls Kontaktflächen 12. Zur Unterscheidung sollen die Kontaktflächen 8 als erste Kontaktfläche 8 und die Kontaktflächen 12 als zweite Kontaktflächen 12 bezeichnet werden. Die ersten Kontaktflächen 8 sind auf der einen Seite 9 der Leiterplatine 10 in einem vorgegebenen Muster 13 angeordnet. Dabei handelt es sich um ein in einer Ebene liegendes Muster 13. Die auf der anderen Seite 11 der Leiterplatine 10 liegenden zweiten Kontaktflächen 12 sind in einem weiteren vorgegebenen Muster 14 angeordnet. Hierbei handelt es sich ebenfalls um einen in einer Ebene liegendes Muster. Das Muster 14 kann ebenso gestaltet sein wie das Muster 13 oder es gibt Unterschiede zwischen den beiden Mustern 13 und 14. Jeweils eine erste Kontaktfläche 8 ist mit einer zugeordneten zweiten Kontaktfläche 12 elektrisch verbunden. Hierzu sind elektrische Verbindungen 15 vorgesehen, die die Leiterplatine 10 durchsetzen. Die ersten Kontaktflächen 8 befinden sich auf der einen Seite 9 der Leiterplatine 10 in einem ersten Bereich 16, der insbesondere einen zentralen Bereich der Leiterplatine 10 bildet. Die auf der anderen Seite 11 liegenden zweiten Kontaktfläche 12 liegen in einem zweiten Bereich 17 der Leiterplatine 10, wobei der zweite Bereich 17 insbesondere einen zentralen Bereich der Leiterplatine 10 bildet.

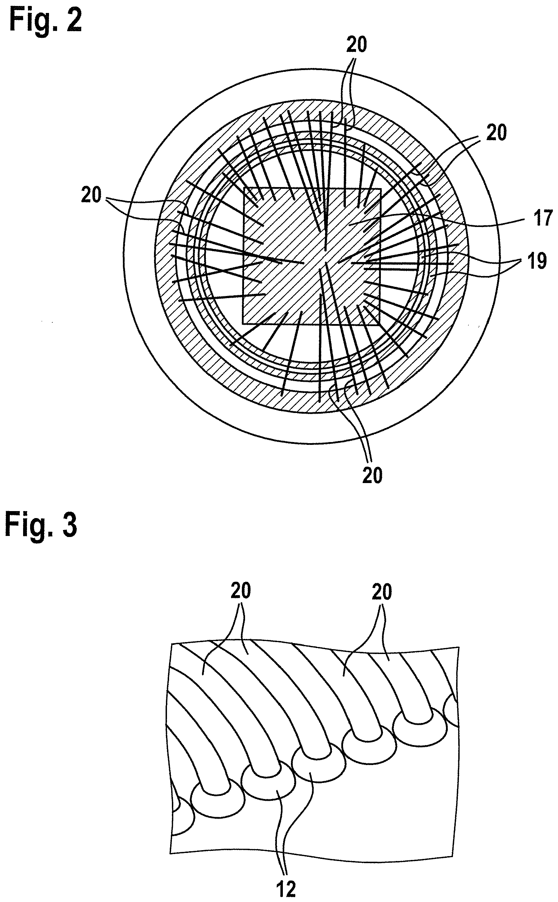

Auf der Seite 11 der Leiterplatine 10 sind dritte Kontaktflächen 18 angeordnet. Die dritten Kontaktflächen 18 befinden sich in einem ersten Abschnitt 19 der Seite 11, der insbesondere einen peripheren Abschnitt 19 der Seite 11 bildet. Die Anordnung ist vorzugsweise derart getroffen, dass sich der erste Abschnitt 19 um den zweiten Bereich 17 herum erstreckt, wie dies insbesondere der Draufsicht der Figur 2 zu entnehmen ist. Der erste Abschnitt 19 kann - wie die Figur 2 zeigt - in mehrere Teilabschnitte unterteilt sein. Im Ausführungsbeispiel der Figur 2 liegen drei ringförmige Teilabschnitte vor, die zueinander konzentrisch liegen, wobei innerhalb der ringförmigen Teilabschnitte der zweite, zentrale Bereich 17 liegt.

Zumindest einige der zweiten Kontaktflächen 12 sind mit zumindest einigen der dritten Kontaktflächen 18 mittels gebondeter Bonddrähte 20 elektrisch verbunden. Die Bonddrähte 20 verlaufen vorzugsweise bogenförmig, so wie aus der Figur 1 ersichtlich. Die Figur 2 verdeutlicht, dass die Bonddrähte 20 - ausgehend vom zweiten, insbesondere zentralen Bereich 17 - etwa radial ausgehen und sich bis zum ersten, vorzugsweise peripheren Abschnitt 19 erstrecken. Die Figur 3 zeigt eine Detaildarstellung. Deutlich ist erkennbar, wie die Bonddrähte 20 endseitig mit den zweiten Kontaktflächen 12 durch Bonden elektrisch verbunden sind.

Die dritten Kontaktflächen 18 sind mittels elektrischer Einrichtungen 21 mit mindestens einer Leiterplatte 22 verbunden. Beim Ausführungsbeispiel der Figur 1 liegt eine Leiterplatte 22 vor, die einen zentralen Durchbruch 23 aufweist, in dem sich der Kontaktkopf 2 befindet. Die Anordnung ist vorzugsweise derart getroffen, dass auf der einen Seite 9 der Leiterplatine 10 in mindestens einem zweiten, insbesondere peripheren Abschnitt 24 von dieser erste Kontaktbauteile 25 liegen, die mit den dritten Kontaktflächen 18 elektrisch verbunden sind. Diese elektrischen Verbindungen 26 verlaufen durch die Leiterplatine 10 hindurch. Die Leiterplatte 22 weist auf ihrer der Leiterplatine 10 zugewandten Seite 27 zweite Kontaktbauteile 28 auf. Die ersten Kontaktbauteile 25 sind mit den zweiten Kontaktbauteilen 28 mittels elektrischer Verbindungen 29, insbesondere federnd nachgiebigen Berührungskontaktierungen 30 elektrisch verbunden. Die genannten elektrischen Einrichtungen 21 verbinden somit elektrisch die Leiterplatine 10 mit der Leiterplatte 22. Insbesondere kann vorgesehen sein, dass die ersten Kontaktbauteile 25 und/oder die zweiten Kontaktbauteile 28 - wie in Figur 1 gezeigt - als vierte Kontaktflächen 31 ausgebildet sind. Gemäß Figur 1 ist die Anordnung derart getroffen, dass die elektrischen Einrichtungen 21 über mindestens einen elektrischen Zwischenverbinder 32 verbunden sind. Der elektrische Zwischenverbinder 32 weist auf einander gegenüberliegenden Seiten Kontakteinrichtungen auf, die als zweite Federkontakte 33 ausgebildet sind. Diese elastisch nachgiebigen Federkontakte 33 liegen somit in Berührungskontaktierung zu den vierten Kontaktflächen 31. Alternativ kann auch vorgesehen sein, dass ein Zwischenverbinder verwendet wird, der auf einander gegenüberliegenden Seiten Kontakteinrichtungen aufweist, die als fünfte Kontaktflächen ausgebildet sind. In einem solchen Falle sind die ersten Kontaktbauteile 25 und die zweiten Kontaktbauteile 28 der Leiterplatine 10 und der Leiterplatte 22 als hervorstehende erste Federkontakte ausgebildet.

Die zweiten Kontaktbauteile 28, insbesondere die vierten Kontaktflächen 31 der Leiterplatte 22 sind über elektrische Verbindungen 34 mit fünften Kontaktflächen 35 der Leiterplatte 22 verbunden. Die zweiten Kontaktbauteile 28, insbesondere vierten Kontaktflächen 31, liegen bezüglich der Leiterplatte 22 in einem zentralen Bereich von dieser, insbesondere um den Durchbruch 23 herum. Die fünften Kontaktflächen 35 liegen in einem peripheren Bereich der Leiterplatte 22. Mittels nicht dargestellter Kabelverbindungen werden die fünften Kontaktflächen 35 mit einer nicht dargestellten Prüfeinrichtung elektrisch verbunden.

Aufgrund des aus der Figur 1 ersichtlichen Aufbaus der Kontaktvorrichtung 1 lässt sich der extrem kleine Abstand, der zwischen den Kontaktelementen 4 vorliegt bis auf einen hinreichend großen Abstand der fünften Kontaktfläche 35 vergrößern, sodass an den fünften Kontaktflächen 35 beispielsweise die für den Anschluss der Prüfeinrichtung erforderlichen Lötarbeiten problemlos durchgeführt werden können.

Die Figur 1 zeigt in schematischer Darstellung, dass die zweiten Kontaktflächen 12 auf gleicher Höhe wie die dritten Kontaktflächen 18 liegen, sodass die Bondarbeiten zum Bonden der Bonddrähte 20 auf einer Ebene durchgeführt werden. Ferner ist der Figur 1 schematisch zu entnehmen, dass zur Höhenabstandseinstellung von Leiterplatine 10 und Leiterplatte 22 mindestens ein auswechselbares Distanzelement 36 von wählbarer Dicke zwischen Leiterplatine 10 und Leiterplatte 22 angeordnet ist. Hierdurch stellt sich ein entsprechendes Maß einer Bauhöhe b zwischen den Enden 6 der Kontaktelemente 4 und der dem Prüfling zugewandten Seite 37 der Leiterplatte 22 ein. Je nach gewählter Dicke des Distanzelements 36 lässt sich die Bauhöhe b entsprechend variieren, um bestimmte Vorgaben der unterschiedlichen Anwender der Kontaktvorrichtung 1 erfüllen zu können. Aufgrund der federnachgiebigen elektrischen Verbindungen 21 zwischen der Leiterplatine 10 und der Leiterplatte 22 ist trotz einer Variation der Bauhöhe b stets ein guter elektrischer Kontakt zwischen der Leiterplatine 10 und der Leiterplatte 22 gewährleistet.

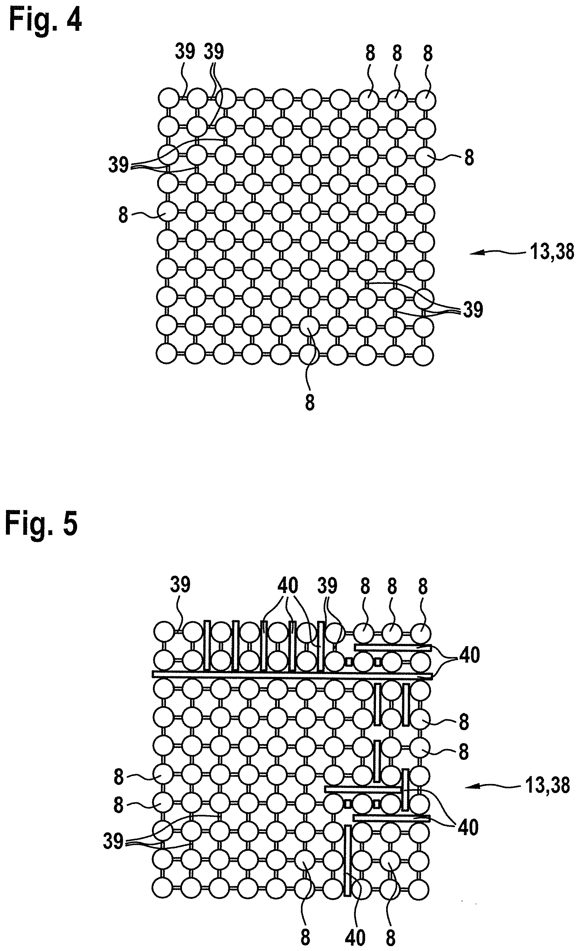

Die Figuren 4 und 5 zeigen die Anordnung der ersten Kontaktflächen 8 in dem vorgegebenen Muster 13. Vorzugsweise kann die Anordnung der zweiten Kontaktflächen 12 in dem weiteren vorgegebenen Muster 14 erfolgen, das gleich wie das Muster 13 ausgebildet ist. Nachstehend wird jedoch nur auf die ersten Kontaktflächen 8 eingegangen, wobei entsprechendes für die zweiten Kontaktflächen 12 gilt, jedoch nicht extra erwähnt wird.

Gemäß Figur 4 handelt es sich bei dem vorgegebenen Muster 13 um ein zweidimensionales Matrixmuster 38, das heißt, die ersten Kontaktflächen 8 sich schachbrettartig verteilt, wobei sie jedoch nicht unmittelbar aneinander stoßen, sondern über elektrische Leiter 39 miteinander elektrisch verbunden sind. Die Figur 4 zeigt diesen Zustand, bei dem sämtliche erste Kontaktflächen 8 über in x- und y-Richtung verlaufende elektrische Leiter 39 miteinander verbunden sind. Die elektrischen Leiter 39 sind also ebenfalls matrixartig angeordnet. Der aus der Figur 4 hervorgehende Zustand ist ein Ausgangszustand, das heißt, er ist nicht geeignet, um die elektrische Prüfung des Prüflings durchzuführen, da alle ersten Kontaktflächen 8 im Kurzschluss zueinander stehen. Um eine Anpassung an die elektrische Schaltung des Prüflings vorzunehmen, ist vorgesehen, dass mindestens einer der Leiter 39 durchtrennt ist, insbesondere laserdurchtrennt ist. Die aus der Figur 5 hervorgehenden rechteckigen Kästen deuten das Durchtrennen, insbesondere Laserdurchtrennen, der entsprechenden Leiter 8 an. Auf diese Art und Weise werden entsprechende Stromwege zwischen dem Prüfling und der Prüfeinrichtung gebildet, wobei gemäß Figur 5 auch größere Flächen beibehalten werden können, die elektrisch zusammenhängend sind, also keine durchtrennten Leiter 39 aufweisen. Diese Flächen können genutzt werden, um dort beispielsweise elektrische/elektronische Bauteile anzuordnen, die an entsprechende erste Kontaktflächen 8 elektrisch angeschlossen werden. Die Figur 5 verdeutlicht demzufolge den betriebsbereiten Zustand der Kontaktvorrichtung 1 in Hinblick auf die ersten Kontaktflächen 8. Die elektrischen Leiter 39 können als Leiterbahnen oder Leiterstege ausgebildet sein. Die Durchtrennungen, insbesondere Laserdurchtrennungen 40, separieren entsprechende erste Kontaktflächen 8 oder mehrere erste Kontaktflächen 8 von benachbarten ersten Kontaktflächen 8. Auf diese Art und Weise ist es insbesondere möglich, Stromwege für die Zuleitung eines elektrischen Versorgungspotentials zu bilden und/oder Massebereiche zu schaffen.

Das Bonden der Bonddrähte 20 und/oder das Durchtrennen, insbesondere Laserdurchtrennen, der elektrischen Leiter 39 erfolgt vorzugsweise jeweils vollautomatisch, das heißt, es werden softwaregesteuerte Maschinen eingesetzt, die die entsprechenden Arbeiten selbsttätig durchführen.

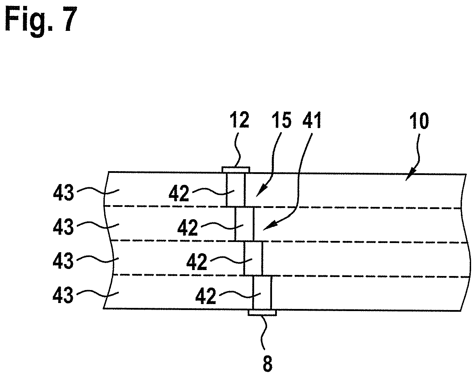

Die Figur 7 verdeutlicht die Ausgestaltung der elektrischen Verbindungen 15 und/oder elektrischen Verbindungen 26. Dargestellt ist eine elektrische Verbindung 15 der Leiterplatine 10. Die nachstehend erläuterte Ausgestaltung gilt in entsprechender Weise für die elektrischen Verbindungen 26. Grundsätzlich ist es möglich, dass die elektrische Verbindung 15 geradlinig die Leiterplatine 10 durchsetzt, also in einer Richtung, die der Längserstreckung der Kontaktelemente 4 (ohne Berücksichtigung von deren seitlichen Ausfedern und/oder deren Schrägstellen) entspricht. Um jedoch eine Kontaktabstandsvergrößerung zwischen den ersten Kontaktflächen 8 und den zweiten Kontaktflächen 12 zu erreichen, kann auch ein schräg nach außen erfolgender Verlauf gemäß Figur 7 vorgesehen sein. Insbesondere sind die ersten Kontaktflächen 8 mit den zweiten Kontaktflächen 12 über erste Durchkontaktierungen 41 verbunden. Die aus der Figur 7 hervorgehende Durchkontaktierung setzt sich aus mehreren ersten Durchkontaktierungsbereichen 42 zusammen. Je ein Durchkontaktierungsbereich 42 erstreckt sich durch eine Lage 43 der als mehrlagige Platine aufgebauten Leiterplatine 10. Die Anordnung ist nun so getroffen, dass die ersten Durchkontaktierungsbereiche 42 versetzt, jedoch zumindest teilweise überlappend zueinander liegen, wodurch sich der erwähnte "Schrägverlauf" ergibt und wodurch eine Kontaktabstandsaufweitung herbeigeführt wird.

In entsprechender Weise - wie zu der Figur 7 beschrieben - können sich die dritten Kontaktflächen 18 mit den ersten Kontaktbauteilen 25 über zweite Durchkontaktierungen verbinden, wobei zumindest einige der zweiten Durchkontaktierungen jeweils aus mehreren zweiten Durchkontaktierungsbereichen zusammengesetzt sind, und wobei bei diesen zweiten Durchkontaktierungen jeweils die zweiten Durchkontaktierungsbereiche fluchtend und/oder versetzt, jedoch zumindest teilweise überlappend zueinander liegen.

Vorzugsweise kann insbesondere vorgesehen sein, dass das vorgegebene Muster 13, insbesondere zweidimensionale Matrixmuster 38, der Anordnung der Führungsbohrungen 3 im Bereich der Leiterplatine 10 entspricht. Diese Ausgestaltung liegt somit bei der Führungsplatte 5 vor, die eng benachbart zur Leiterplatine 10 liegt. Bei der anderen Führungsplatte 5, die nahe der Enden 6 der Kontaktelemente 4 liegt, also auf Seiten des Prüflings, ist die Anordnung der Führungsbohrungen 3 vorzugsweise nach einem dem Prüfling entsprechenden Individualmuster vorgenommen. Entsprechend der am Prüfling zu kontaktierenden elektrischen Anschlüsse ist demzufolge das Individualmuster realisiert, sodass es hierdurch dazu kommen kann, dass die Kontaktelemente 4 hinsichtlich ihrer Längserstreckungen nicht parallel, sondern schräg zueinander verlaufen.

Die Kontaktelemente 4, die insbesondere als Knickdrähte ausgebildet sind, können mikrosystemtechnische Kontaktelemente 4 sein, also winzige Abmessungen aufweisen.

Grundsätzlich ist es möglich, bei den dritten Kontaktflächen 18, den ersten Kontaktbauteilen 25, den zweiten Kontaktbauteilen 28 und/oder den Kontakteinrichtungen ebenfalls durchtrennbare, insbesondere laserdurchtrennbare Leiter 39 vorzusehen, das heißt, hier liegen ebenfalls elektrische Leiter 39 zwischen den einzelnen Elementen vor, wobei mindestens einer dieser Leiter 39 durchtrennt, insbesondere laserdurchtrennt ist.

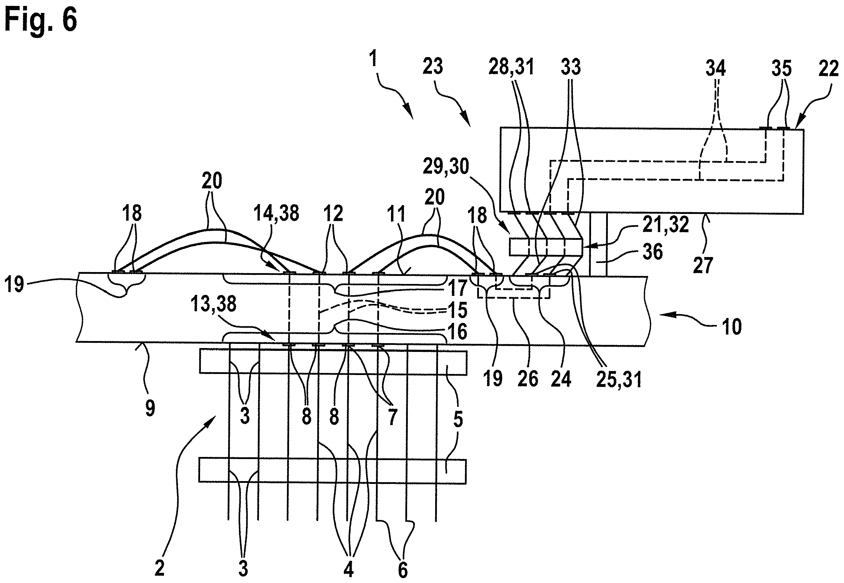

Die Figur 6 verdeutlicht ein weiteres Ausführungsbeispiel der Erfindung, das im Wesentlichen dem Ausführungsbeispiel der Figur 1 entspricht, sodass auf das Ausführungsbeispiel der Figur 1 und der zugehörigen Beschreibung weitestgehend Bezug genommen wird. Unterschiedlich ist lediglich, dass sich die Leiterplatte 22 nicht der einen Seite 9 der Leiterplatine 10, sondern der anderen Seite 11 der Leiterplatine 10 zugeordnet ist. Ferner ist insbesondere vorgesehen, dass die zweiten Kontaktbauteile 28 und die fünften Kontaktflächen 35 nicht auf derselben Seite der Leiterplatte 22 liegen (Figur 1), sondern auf einander gegenüberliegenden Seiten der Leiterplatte 22 (Figur 6).

Bei allen Ausführungsbeispielen ist vorgesehen, dass ein Prüfling mittels eines Hubtischs für die Durchführung der elektrischen Prüfung angehoben wird und gegen die Enden 6 der Kontaktelemente 4 gedrängt wird, sodass sich elektrische Berührungskontaktierungen ergeben. Mittels der erwähnten Prüfeinrichtung können dann über die Kontaktvorrichtung Stromkreise geschaltet werden, um den elektrischen Prüfling, insbesondere Wafer, auf seine elektrische Funktionsfähigkeit zu prüfen.

## Patentansprüche

1. Kontaktvorrichtung (1) für eine elektrische Berührungskontaktierung zur elektrischen Prüfung eines elektrischen Prüflings, insbesondere Wafers, mit einem Kontaktkopf (2) und mit mindestens einer Leiterplatine (10), wobei der Kontaktkopf (2) eine Vielzahl von Führungsbohrungen (3) aufweist, in denen längliche, durch die Berührungskontaktierung des Prüflings seitlich federnd ausknickende Kontaktelemente (4) längsverschieblich lagern, deren eine Enden (6) der Berührungskontaktierung des Prüflings dienen und deren andere Enden (7) in Berührungskontakt zu in einem vorgegebenen Muster (13) angeordneten, ersten Kontaktflächen (8) stehen, die sich auf einer Seite (9) der Leiterplatine (10) in einem ersten insbesondere zentralen Bereich (16) von dieser befinden, wobei auf der anderen Seite (11) der Leiterplatine (10) in einem zweiten insbesondere zentralen Bereich (17) von dieser insbesondere in einem weiteren vorgegebenen Muster (14) angeordnete, zweite Kontaktflächen (12) liegen, die mit den ersten Kontaktflächen (8) durch die Leiterplatine (10) hindurch elektrisch verbunden sind, auf der anderen Seite (11) der Leiterplatine (10) in mindestens einem ersten insbesondere peripheren Abschnitt (19) von dieser dritte Kontaktflächen (18) liegen, zumindest einige der zweiten Kontaktflächen (12) mit zumindest einigen der dritten Kontaktflächen (18) mittels gebondeter Bonddrähte (20) elektrisch verbunden sind, wobei zumindest ein Anteil der ersten Kontaktflächen (8) und/oder zumindest ein Anteil der zweiten Kontaktflächen (12) jeweils mittels durchtrennbarer Leiter (39) miteinander elektrisch verbunden sind und mindestens einer dieser Leiter (39) durchtrennt ist, **dadurch gekennzeichnet, dass** die ersten Kontaktflächen (8) mit den zweiten Kontaktflächen (12) direkt über erste Durchkontaktierungen (41) verbunden sind, das vorgegebene Muster (13) der Anordnung der ersten Kontaktflächen (8) und/oder das insbesondere vorgegebene weitere Muster (14) der zweiten Kontaktflächen (12) jeweils ein zweidimensionales Matrixmuster (38) ist und die durchtrennbaren Leiter (39) matrixartig angeordnet sind.

2. Kontaktvorrichtung nach Anspruch 1, **dadurch gekennzeichnet, dass** die durchtrennbaren Leiter (39) als Leiterbahnen oder Leiterstege ausgebildet sind.

3. Kontaktvorrichtung nach einem der vorhergehenden Ansprüche, **dadurch gekennzeichnet, dass** der mindestens eine durchtrennte Leiter (39) laserdurchtrennt ist.

4. Kontaktvorrichtung nach einem der vorhergehenden Ansprüche, **gekennzeichnet durch** mindestens eine Leiterplatte (22), wobei die dritten Kontaktflächen (18) mit der Leiterplatte (22) elektrisch verbunden sind.

5. Kontaktvorrichtung nach einem der vorhergehenden Ansprüche, **dadurch gekennzeichnet, dass** auf der einen Seite (9) der Leiterplatine (10) in mindestens einem zweiten insbesondere peripheren Abschnitt (24) von dieser erste Kontaktbauteile (25) liegen, die mit den dritten Kontaktflächen (18) durch die Leiterplatine (10) hindurch elektrisch verbunden sind, die Leiterplatte (22) auf ihrer der Leiterplatine (10) zugewandten Seite (27) zweite Kontaktbauteile (28) aufweist, und wobei die ersten Kontaktbauteile (25) mit den zweiten Kontaktbauteilen (28) mittels elektrischer Verbindungen (29), insbesondere federnd nachgiebigen Berührungskontaktierungen (30), elektrisch verbunden sind.

6. Kontaktvorrichtung nach einem der vorhergehenden Ansprüche, **dadurch gekennzeichnet, dass** auf der anderen Seite (11) der Leiterplatine (10) in mindestens einem zweiten insbesondere peripheren Abschnitt (24) von dieser erste Kontaktbauteile (25) liegen, die mit den dritten Kontaktflächen (18) elektrisch verbunden sind, die Leiterplatte (22) auf ihrer der Leiterplatine (10) zugewandten Seite (27) zweite Kontaktbauteile (28) aufweist, und wobei die ersten Kontaktbauteile (25) mit den zweiten Kontaktbauteilen (28) mittels elektrischer Verbindungen (29), insbesondere federnd nachgiebigen Berührungskontaktierungen (30), elektrisch verbunden sind.

7. Kontaktvorrichtung nach einem der Ansprüche 5 oder 6, **dadurch gekennzeichnet, dass** die ersten Kontaktbauteile (25) mit den zweiten Kontaktbauteilen (28) über mindestens einen elektrischen Zwischenverbinder (32) (Interposer) elektrisch verbunden sind.

8. Kontaktvorrichtung nach einem der Ansprüche 5 bis 7, **dadurch gekennzeichnet, dass** die ersten Kontaktbauteile (25) und/oder die zweiten Kontaktbauteile (28) vierte Kontaktflächen (31) sind.

9. Kontaktvorrichtung nach einem der Ansprüche 5 bis 8, **dadurch gekennzeichnet, dass** die ersten Kontaktbauteile (25) und/oder die zweiten Kontaktbauteile (28) hervorstehende erste Federkontakte sind.

10. Kontaktvorrichtung nach Anspruch 7, **dadurch gekennzeichnet, dass** der Zwischenverbinder (32) auf einander gegenüberliegenden Seiten Kontakteinrichtungen (21) aufweist, die als fünfte Kontaktflächen und/oder hervorstehende zweite Federkontakte (33) ausgebildet sind.

11. Kontaktvorrichtung nach einem der vorhergehenden Ansprüche, **dadurch gekennzeichnet, dass** die Führungsbohrungen (3) im Bereich der Leiterplatine (10) in dem vorgegebenen Muster (13), insbesondere zweidimensionalen Matrixmuster (38), angeordnet sind.

12. Kontaktvorrichtung nach einem der vorhergehenden Ansprüche, **dadurch gekennzeichnet, dass** die Führungsbohrungen (3) prüflingsseitig in einem dem Prüfling entsprechenden Individualmuster angeordnet sind.

13. Kontaktvorrichtung nach einem der vorhergehenden Ansprüche, **dadurch gekennzeichnet, dass** sich zumindest einige der ersten Durchkontaktierungen (41) jeweils aus mehreren ersten Durchkontaktierungsbereichen (42) zusammensetzen, wobei bei diesen ersten Durchkontaktierungen (41) jeweils die ersten Durchkontaktierungsbereiche (42) fluchtend oder versetzt, jedoch zumindest teilweise überlappend zueinander liegen.

14. Kontaktvorrichtung nach Anspruch 5, **dadurch gekennzeichnet, dass** die dritten Kontaktflächen (18) mit den ersten Kontaktbauteilen (25) über zweite Durchkontaktierungen verbunden sind.

15. Kontaktvorrichtung nach Anspruch 14, **dadurch gekennzeichnet, dass** sich zumindest einige der zweiten Durchkontaktierungen jeweils aus mehreren zweiten Durchkontaktierungsbereichen zusammensetzen, wobei bei diesen zweiten Durchkontaktierungen jeweils die zweiten Durchkontaktierungsbereiche fluchtend oder versetzt, jedoch zumindest teilweise überlappend zueinander liegen.

16. Kontaktvorrichtung nach einem der vorhergehenden Ansprüche, **dadurch gekennzeichnet, dass** die zweiten Kontaktflächen (12) und die dritten Kontaktflächen (18) auf gleicher Höhe liegen.

17. Kontaktvorrichtung nach Anspruch 4, **dadurch gekennzeichnet, dass** zur Höhenabstandseinstellung von Leiterplatine (10) und Leiterplatte (22) mindestens ein auswechselbares Distanzelement (36) von wählbarer Dicke zwischen Leiterplatine (10) und Leiterplatte (22) angeordnet ist.

18. Kontaktvorrichtung nach einem der vorhergehenden Ansprüche, **dadurch gekennzeichnet, dass** die Kontaktelemente (4) mikrosystemtechnische Kontaktelemente (4) sind.

19. Kontaktvorrichtung nach Anspruch 5, **dadurch gekennzeichnet, dass** die dritten Kontaktflächen (18), die ersten Kontaktbauteile (25), die zweiten Kontaktbauteile (28) und/oder die Kontakteinrichtungen (21) jeweils mittels durchtrennbarer, insbesondere laserdurchtrennbarer, Leiter (39) miteinander elektrisch verbunden sind, wobei mindestens einer dieser Leiter (39) durchtrennt, insbesondere laserdurchtrennt ist.

## Claims

1. Contact device (1) for an electric touch contacting for electrically testing an electric test object, in particular a wafer, comprising a contact head (2) and at least one printed circuit board (10), wherein the contact head (2) has a plurality of guide bores (3), in which elongated contact elements (4) that buckle elastically in a lateral direction upon touch contacting the test object, are mounted in a longitudinally movable manner; one ends (6) of the contact elements (4) are used to touch contact the test object and the other ends (7) are in touch contact with first contact surfaces (8) which are arranged in a specified pattern (13) and which are located on a face (9) of the printed circuit board (10) in a first, particularly central region (16) of the printed circuit board face (9), wherein second contact surfaces (12) which are arranged particularly in a further specified pattern (14) and which are electrically connected to the first contact surfaces (8) through the printed circuit board (10) lie on the other face (11) of the printed circuit board (10) in a second, particularly central region (17) of the printed circuit board face (11); third contact surfaces (18) lie on the other face (11) of the printed circuit board (10) in at least one first particularly peripheral portion (19) of the printed circuit board face (11); at least some of the second contact surfaces (12) are electrically connected to at least some of the third contact surfaces (18) by means of bonded bonding wires (20); wherein at least some of the first contact surfaces (8) and/or at least some of the second contact surfaces (12) are each electrically connected to one another by means of severable conductors (39), and at least one of said conductors (39) is severed, **characterized in that** first contact surfaces (8) are directly connected to the second contact surfaces (12) by means of first through-connections (41), the specified pattern (13) of the arrangement of the first contact surfaces (8) and/or the particularly specified further pattern (14) of the second contact surfaces (12) is each a two-dimensional matrix pattern (38), and the severable conductors (39) are arranged in a matrix-like pattern.

2. Contact device according to claim 1, **characterized in that** the severable conductors (39) are configured as conductor paths or conductor webs.

3. Contact device according to one of the previous claims, **characterized in that** the at least one severed conductor (39) is laser-severed.

4. Contact device according to one of the previous claims, **characterized by** at least one conductor board (22), wherein the third contact surfaces (18) are electrically connected to the conductor board (22).

5. Contact device according to one of the previous claims, **characterized in that** first contact components (25) lie on the one face (9) of the printed circuit board (10) in at least a second, particularly peripheral portion (24) of the printed circuit board face (9) which are electrically connected to the third contact surfaces (18) through the printed circuit board (10); the conductor board (22) comprises second contact components (28) on the side (27) facing the printed circuit board (10), and wherein the first contact components (25) are electrically connected to the second contact components (28) by means of electric connections (29), particularly elastically resilient touch contacts (30).

6. Contact device according to one of the previous claims, **characterized in that** first contact components (25) lie on the other face (11) of the printed circuit board (10) in at least a second, particularly peripheral portion (24) of the printed circuit board face (11) which are electrically connected to the third contact surfaces (18); the conductor board (22) comprises second contact components (28) on the side (27) facing the printed circuit board (10), and wherein the first contact components (25) are electrically connected to the second contact components (28) by means of electric connections (29), particularly elastically resilient touch contacts (30).

7. Contact device according to one of the claims 5 or 6, **characterized in that** the first contact components (25) are electrically connected to the second contact components (28) by means of at least one electric interposer (32).

8. Contact device according to one of the claims 5 to 7, **characterized in that** the first contact components (25) and/or the second contact components (28) are fourth contact surfaces (31).

9. Contact device according to one of the claims 5 to 8, **characterized in that** the first contact components (25) and/or the second contact components (28) are protruding first spring contacts.

10. Contact device according to claim 7, **characterized in that** the interposer (32) comprises contact means (21) on opposite sides which are configured as fifth contact surfaces and/or protruding second spring contacts (33).

11. Contact device according to one of the previous claims, **characterized in that** the guide bores (3) in the region of the printed circuit board (10) are arranged in the specified pattern (13), particularly the two-dimensional matrix pattern (38).

12. Contact device according to one of the previous claims, **characterized in that** the guide bores (3) are arranged on the side of the test object in an individual pattern which corresponds to the test object.

13. Contact device according to one of the previous claims, **characterized in that** at least some of the first through-connections (41) each are composed of a plurality of first through-connection areas (42), wherein the first through-connection areas (42) of these first through-connections (41) each lie aligned or offset but at least to some extent overlapping to one another.

14. Contact device according to claim 5, **characterized in that** the third contact surfaces (18) are connected to the first contact components (25) by means of second through-connections.

15. Contact device according to claim 14, **characterized in that** at least some of the second through-connections are each composed of a plurality of second through-connection areas, wherein the second through-connection areas of these second through-connections each lie aligned or offset but at least to some extent overlapping to one another.

16. Contact device according to one of the previous claims, **characterized in that** the second contact surfaces (12) and the third contact surfaces (18) lie at the same height.

17. Contact device according to claim 4, **characterized in that** at least one replaceable spacer element (36) of selectable thickness is arranged between printed circuit board (10) and conductor board (22) for adjusting the height distance of printed circuit board (10) and conductor board (22).

18. Contact device according to one of the previous claims, **characterized in that** the contact elements (4) are microsystem-technical contact elements (4).

19. Contact device according to claim 5, **characterized in that** the third contact surfaces (18), the first contact components (25), the second contact components (28) and/or the contact means (21) are each electrically connected to one another by means of severable, particularly laser-severable conductors (39), wherein at least one of these conductors (39) is severed, particularly laser-severed.

## Revendications

1. Dispositif de contact (1) pour la connexion électrique par contact pour le contrôle électrique d'un objet d'essai électrique, en particulier une plaquette, comportant une tête de contact (2) et au moins une carte de circuit imprimé (10), la tête de contact (2) ayant une pluralité d'alésages de guidage (3) dans lesquels des éléments de contact allongés (4), se déformant latéralement, élastiquement à la manière d'un ressort, par la connexion par contact avec l'objet d'essai, sont logés de manière à pouvoir être déplacés longitudinalement, dont les premières extrémités (6) servent pour la connexion par contact de l'objet d'essai et les autres extrémités (7) sont connecter par contact avec des premières surfaces de contact (8) arrangées dans un motif prédéfini (13) qui sont situées sur un côté (9) de la carte de circuit imprimé (10) dans une première région (16), notamment dans une région centrale de celle-ci, sur l'autre côté (11) de la carte de circuit imprimé (10) étant situées, dans une seconde région (17), notamment dans une région centrale de celle-ci, des deuxièmes surfaces de contact (12), notamment arrangées dans un autre motif prédéfini (14), les deuxièmes surfaces étant reliées électriquement avec les premières surfaces de contact (8) à travers la carte de circuit imprimé (10), et sur l'autre côté (11) de la carte de circuit imprimé (10), dans au moins une première partie (19), notamment dans une partie périphérique de celle-ci, étant situées des troisièmes surfaces de contact (18), au moins certaines des deuxièmes surfaces de contact (12) étant reliées électriquement avec au moins certaines des troisièmes surfaces de contact (18) au moyen des fils de connexion (20) reliés, au moins une portion des premières surfaces de contact (8) et/ou au moins une portion des deuxièmes surfaces de contact (12) étant reliées électriquement les unes avec les autres au moyen des conducteurs (39) pouvant être coupés et au moins un des conducteurs (39) étant coupé, **caractérisé en ce que** les premières surfaces de contact (8) sont directement reliées avec les deuxièmes surfaces de contact (12) par premiers vias (trous d'interconnexion) (41), le motif prédéfini (13) de l'arrangement des premières surfaces de contact (8) et/ou l'autre motif (14) notamment prédéfini des deuxièmes surfaces de contact (12) sont chacun un motif de matrice bidimensionnelle (38), et les conducteurs (39) pouvant être coupés sont arrangés sous forme de matrice.

2. Dispositif de contact selon la revendication 1, **caractérisé en ce que** les conducteurs (39) pouvant être coupés sont configurés sous forme de pistes conductrices ou de bandes conductrices.

3. Dispositif de contact selon l'une quelconque des revendications précédentes, **caractérisé en ce que** le au moins un conducteur coupé (39) est coupé au moyen d'un laser.

4. Dispositif de contact selon l'une quelconque des revendications précédentes, **caractérisé par** au moins un circuit imprimé (22), les troisièmes surfaces de contact (18) étant reliées électriquement avec le circuit imprimé (22).

5. Dispositif de contact selon l'une quelconque des revendications précédentes, **caractérisé en ce que** sur l'un côté (9) de la carte de circuit imprimé (10), dans au moins une seconde partie (24), notamment une partie périphérique de celle-ci, sont situées des premiers composants de contact (25) qui sont électriquement reliés avec les troisièmes surfaces de contact (18) à travers la carte de circuit imprimé (10), le circuit imprimé (22) présente, sur son côté (27) faisant face à la carte de circuit imprimé (10), des seconds composants de contact (28), et dans lequel les premiers composants de contact (25) sont électriquement reliés avec les seconds composants de contact (28) au moyen des connexions électriques (29), notamment au moyen des connexions par contact (30) élastiques à ressort.

6. Dispositif de contact selon l'une quelconque des revendications précédentes, **caractérisé en ce que** sur l'autre côté (11) de la carte de circuit imprimé (10), dans au moins une seconde partie (24), notamment une partie périphérique de celle-ci, sont situées des premiers composants de contact (25) qui sont électriquement reliés avec les troisièmes surfaces de contact (18), le circuit imprimé (22) présente, sur son côté (27) faisant face à la carte de circuit imprimé (10), des seconds composants de contact (28), et dans lequel les premiers composants de contact (25) sont électriquement reliés avec les seconds composants de contact (28) au moyen des connexions électriques (29), notamment au moyen des connexions par contact (30) élastiques à ressort.

7. Dispositif de contact selon l'une quelconque des revendications 5 ou 6, **caractérisé en ce que** les premiers composants de contact (25) sont électriquement reliés avec les seconds composants de contact (28) par au moins un connecteur électrique intermédiaire (32) ("interposer").

8. Dispositif de contact selon l'une quelconque des revendications 5 à 7, **caractérisé en ce que** les premiers composants de contact (25) et/ou les seconds composants de contact (28) sont des quatrièmes surfaces de contact (31).

9. Dispositif de contact selon l'une quelconque des revendications 5 à 8, **caractérisé en ce que** les premiers composants de contact (25) et/ou les seconds composants de contact (28) sont des premiers contacts à ressort saillants.

10. Dispositif de contact selon la revendication 7, **caractérisé en ce que** le connecteur intermédiaire (32) présente, sur les côtés opposés, des arrangements de contact (21) configurés sous forme de cinquièmes surfaces de contact et/ou de seconds contacts à ressort (33) saillants.

11. Dispositif de contact selon l'une quelconque des revendications précédentes, **caractérisé en ce que** les alésages de guidage (3) sont arrangés dans la région de la carte de circuit imprimé (10) sous forme de motif prédéfini (13), notamment de motif de matrice bidimensionnelle (38).

12. Dispositif de contact selon l'une quelconque des revendications précédentes, **caractérisé en ce que** les alésages de guidage (3) sont arrangés, à côté d'objet d'essai, sous forme d'un motif individuel correspondant à l'objet d'essai.

13. Dispositif de contact selon l'une quelconque des revendications précédentes, **caractérisé en ce qu'au** moins certains des premiers vias (41) respectivement consistent en plusieurs premières régions de vias (42), les premières régions de vias (42) étant arrangées, pour les premiers vias (41), respectivement alignées ou décalées, mais se chevauchant au moins partiellement.

14. Dispositif de contact selon la revendication 5, **caractérisé en ce que** les troisièmes surfaces de contact (18) sont reliées avec les premiers composants de contact (25) au moyen des seconds vias.

15. Dispositif de contact selon la revendication 14, **caractérisé en ce qu'**au moins certains des seconds vias respectivement consistent en plusieurs secondes régions de vias, les secondes régions de vias étant arrangées, pour les seconds vias, respectivement alignées ou décalées, mais se chevauchant au moins partiellement.

16. Dispositif de contact selon l'une quelconque des revendications précédentes, **caractérisé en ce que** les deuxièmes surfaces de contact (12) et les troisièmes surfaces de contact (18) sont situées à la même hauteur.

17. Dispositif de contact selon la revendication 4, **caractérisé en ce qu'**au moins un élément d'espacement (36) remplaçable, d'épaisseur au choix, est arrangé entre la carte de circuit imprimé (10) et le circuit imprimé (22) pour ajuster la distance en hauteur entre la carte de circuit imprimé (10) et le circuit imprimé (22).

18. Dispositif de contact selon l'une quelconque des revendications précédentes, **caractérisé en ce que** les éléments de contact (4) sont des éléments de contact (4) de la technologie des microsystèmes.

19. Dispositif de contact selon la revendication 5, **caractérisé en ce que** les troisièmes surfaces de contact (18), les premiers composants de contact (25), les seconds composants de contact (28) et/ou les arrangements de contact (21) sont respectivement reliés entre eux électriquement au moyen des conducteurs (39) pouvant être coupés, notamment pouvant être coupés par laser, dans lequel au moins un des conducteurs (39) est coupé, notamment coupé par laser.
